# FASCICULE DE BREVET EUROPEEN

(11) **EP 0 654 792 B1**
(45) Date de publication et mention de la délivrance du brevet: **29.05.1996**
(21) Numéro de dépôt: 94460043.6
(22) Date de dépôt: 21.11.1994
(51) Int. Cl.: G11C 29/00

(54) **Mémoire non volatile modifiable électriquement avec contrôle d'écriture**
Nicht-flüchtiger elektrisch veränderbarer Speicher mit Schreibsteuerung
Non-volatile electrically alterable memory with write control

(30) Priorité: 23.11.1993 FR 9314211
(43) Date de publication de la demande: 24.05.1995
(73) Titulaire: SGS-THOMSON MICROELECTRONICS S.A., F-94250 Gentilly (FR)
(72) Inventeur: Bahout, Yvon, F-56100 Lorient (FR); Tailliet, François, F-56100 Lorient (FR)
(74) Mandataire: Fournier, Michel Robert Marie

(56) Documents cités:
- EP-A- 0 231 041

## Description

L'invention concerne une mémoire non volatile modifiable électriquement et qui comporte des moyens pour vérifier le bon déroulement des opérations d'écriture.

Ce type de mémoire, couramment appelé EEPROM, est réalisé sous la forme d'un circuit intégré et comporte un ensemble de cellules mémoire, des moyens de sélection de ces cellules ainsi que des moyens de programmation. Le circuit intégré communique avec l'extérieur par l'intermédiaire d'un circuit d'interface prévu pour recevoir les commandes de lecture et d'écriture associées à des informations d'adresse, pour recevoir les données à écrire et pour délivrer les données lues. L'ensemble est contrôlé par un circuit de commande sensible aux signaux de commande reçus de l'interface.

Les moyens de programmation sont constitués d'un générateur de signal de programmation, appelé "haute tension", capable de charger ou décharger les grilles flottantes des transistors constituant les points mémoire. En réponse à une commande d'écriture, le circuit de commande sélectionne en fonction de l'adresse reçue les transistors à programmer et déclenche le fonctionnement du générateur du signal de programmation. L'ensemble de ces opérations est appelé cycle de programmation. Dans certaines réalisations, l'écriture de données peut nécessiter deux cycles de programmation successifs, le premier cycle effectuant une remise à 0 de la totalité des cellules du mot à écrire et le second cycle effectuant une mise à 1 de cellules sélectionnées du mot.

Pour que la mémoire soit correctement programmée, il est indispensable que le générateur de haute tension fournisse une impulsion de tension bien calibrée en niveau et en durée. Dans le cas contraire, les grilles flottantes des transistors risquent d'être incomplètement chargées ou déchargées, ce qui peut provoquer un effacement progressif des données enregistrées. Ce problème se pose en particulier en cas de perturbation ou de coupure de la tension d'alimentation du circuit intégré au cours d'un cycle de programmation.

Aussi le problème que l'invention cherche à résoudre est de pouvoir vérifier si les cycles de programmation s'effectuent correctement.

Le problème de la vérification de l'écriture correcte de données s'est déjà posé pour les mémoires volatiles. Une solution classique consiste à effectuer après chaque écriture une relecture des données écrites et à les comparer aux données qui auraient dû être écrites. Une autre solution consiste à associer aux données à écrire des données redondantes, telles que des bits de parité ou un code détecteur et correcteur d'erreurs. Ces méthodes sont parfaitement valables dans le cas des mémoires volatiles car les états logiques des points mémoire ne présentent aucune ambiguïté. Par contre, dans le cas des mémoires de type EEPROM, on peut se trouver dans des situations où la programmation s'est effectuée de façon incomplète. Ainsi, une relecture après programmation pourrait conduire à la conclusion que l'opération s'est effectuée correctement bien que les données risquent de s'effacer au cours du temps.

Ainsi l'invention a pour but de proposer une solution pour vérifier le bon déroulement des opérations de programmation des mémoires de type EEPROM. Dans ce but, l'invention a pour objet une mémoire non volatile modifiable électriquement comportant un ensemble de cellules mémoire, des moyens d'adressage et de programmation desdites cellules, un circuit d'interface, et au moins une cellule mémoire supplémentaire, ci-après appelée cellule témoin, l'ensemble étant commandé par un circuit de commande comprenant des moyens pour commander sélectivement la programmation de ladite cellule témoin, caractérisée en ce qu'en réponse à toute commande d'écriture reçue par ledit circuit d'interface, le circuit de commande active trois cycles de programmation successifs :
- un premier cycle de programmation de ladite cellule témoin pour effectuer l'écriture d'une première valeur logique binaire déterminée,
- un second cycle de programmation réalisant l'écriture dans ledit ensemble de cellules mémoire de données à écrire et
- un troisième cycle de programmation de ladite cellule témoin pour effectuer l'écriture d'une seconde valeur logique complémentaire de la première.

La solution proposée exploite le fait que les trois cycles sont normalement indissociables et qu'une interruption même momentanée de l'alimentation entraîne une interruption définitive des cycles de programmation suivants. En effet, une interruption de l'alimentation du circuit intégré provoque l'effacement de toutes les informations volatiles du circuit, en particulier les adresses et les variables d'état qui conditionnent le séquencement des cycles de programmation.

La lecture de la cellule témoin fournit donc les informations suivantes :
- si la cellule est dans son état initial (par exemple à 0), on peut seulement en déduire soit que les trois cycles se sont déroulés normalement, soit qu'aucun des trois cycles n'a commencé ;
- si la cellule est dans son état complémentaire (par exemple à 1), on sait avec certitude qu'une perturbation a eu lieu au cours du second ou du troisième cycle et donc que la programmation n'est pas sûre.

La mise en oeuvre la plus simple de l'invention consiste à utiliser une seule cellule témoin pour toute la mémoire.

L'existence de la cellule témoin pourra être exploitée de différentes façons. Selon une première variante, le circuit d'interface communique avec la cellule témoin pour fournir un signal de test représentatif de l'état de la cellule témoin. Cette disposition permet donc de vérifier la qualité de la programmation du dernier mot inscrit en mémoire.

Selon une autre variante de réalisation de l'invention, la mémoire comporte une bascule de test initialement mise à zéro. A la suite du troisième cycle de programmation, le circuit de commande effectue une lecture de ladite cellule témoin et applique le résultat de ladite lecture à l'entrée de positionnement de ladite bascule de test. D'autre part, le circuit d'interface communique avec ladite bascule de test pour fournir un signal de test représentatif de l'état de ladite bascule de test.

Cette disposition permet de vérifier la qualité de l'ensemble des programmations effectuées depuis la dernière mise sous tension de la mémoire.

En général, les mémoires sont organisées en mots de taille fixe associés à des adresses correspondantes. Ainsi, pour pouvoir effectuer une analyse plus fine des défauts de programmation et selon une variante de l'invention, la mémoire comporte une cellule témoin par bloc de mots, un bloc de mots étant constitué des mots ayant un nombre déterminé de bits d'adresse communs. En réponse à une commande d'écriture d'un mot d'un desdits blocs dans la mémoire, le circuit de commande sélectionne une desdites cellules témoins en fonction desdits bits d'adresse communs associés au bloc et applique lesdits premier et troisième cycles de programmation à ladite cellule témoin sélectionnée.

Selon encore une autre possibilité, on pourra prévoir une cellule témoin par mot adressable.

Une mémoire selon le préambule de la revendication 1 est connue de EP-A-0 231 041.

D'autres aspects et variantes de l'invention apparaîtront dans la suite de la description en référence aux figures.
- La figure 1 représente un exemple de réalisation d'une mémoire selon l'invention.
- La figure 2 schématise les cycles de programmation exécutés par la mémoire selon l'invention.
- La figure 3 représente un détail d'une variante de réalisation.

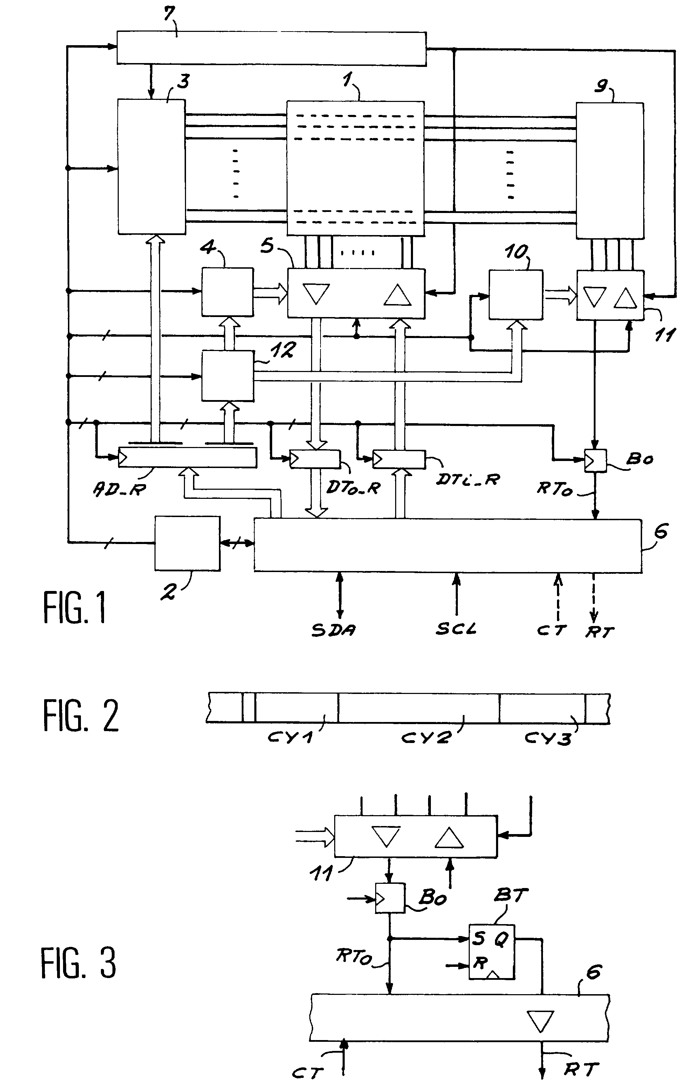

La figure 1 représente un exemple de structure d'une mémoire EEPROM adaptée pour mettre en oeuvre l'invention.

La mémoire comprend une matrice de points mémoire reliés à un décodeur de lignes 3 et à un décodeur de colonnes 4 associés à des circuits de lecture et d'écriture 5. L'écriture de la matrice 1 est effectuée au moyen d'un circuit de programmation 7 essentiellement constitué d'un oscillateur, d'un élévateur de tension et d'un générateur de rampe programmé. Les décodeurs 3 et 4 sont reliés à un registre d'adresse AD-R. Les circuits de lecture et d'écriture 5 sont reliés respectivement à un registre de données de sortie DT0-R et à un registre de données d'entrée DTi-R. Les registres AD-R, DT0-R, DTi-R communiquent avec un circuit d'interface 6. Selon l'exemple représenté, le circuit 6 est relié à un bus conforme à la norme IC qui comprend notamment une ligne d'horloge SCL et une ligne bidirectionnelle SDA permettant de véhiculer les adresses, les données et les commandes. L'ensemble est contrôlé par un circuit de commande 2. Le circuit 2 sera par exemple réalisé au moyen d'un réseau logique programmable (PLA) conçu pour fournir les signaux de commande aux différents circuits en fonction des commandes reçues de la ligne SDA, telles que les commandes de lecture RD ou d'écriture WR.

Les éléments décrits jusqu'à présent sont ceux appartenant à une mémoire de type classique telle que le modèle ST24C04 commercialisé par la Société SGS-THOMSON MICROELECTRONICS.

Pour la mise en oeuvre de l'invention, le schéma est complété par une seconde matrice 9 de points mémoire qui contient les cellules témoins. La matrice 9 est reliée au décodeur de lignes 3 et à un second décodeur de colonnes 10 associé à un second ensemble de circuits de lecture et d'écriture 11. Les décodeurs de colonnes 4 et 10 sont reliés au registre d'adresse AD-R par l'intermédiaire d'un circuit de sélection 12. Les circuits 10, 11 et 12 sont commandés par le circuit de commande 2. Le circuit de lecture et d'écriture 11 est relié à une bascule de sortie B0 qui communique avec le circuit d'interface 6.

Le nombre de cellules témoins associées à chaque ligne de la matrice 9 dépendra de la précision souhaitée pour la vérification. Si on prévoit une cellule témoin pour chaque mot adressable dans la mémoire, une ligne de la matrice 9 contiendra autant de cellules témoins qu'une ligne de la matrice 1 possède de mots. Dans ce cas, les décodeurs 4 et 10 reçoivent le même nombre de bits d'adresse, c'est-à-dire l'adresse de colonne correspondant aux poids faibles du registre d'adresse AD-R.

Selon une autre possibilité, on pourra prévoir une cellule témoin par bloc de mots. Par exemple, si une ligne de la matrice 1 comporte seize mots, et si l'on souhaite une cellule témoin par bloc de quatre mots, la matrice 9 contiendra quatre cellules témoins par ligne. Ainsi, le décodeur 4 sera adressé par l'adresse de colonne formée des quatre derniers bits de l'adresse et le décodeur 10 sera adressé seulement par les deux bits de poids forts de l'adresse de colonne. Bien entendu, des bits autres que les poids forts de l'adresse pourront servir à identifier les blocs de mots.

Dans sa version la plus simple, l'invention pourra n'utiliser qu'une seule cellule témoin, ce qui bien entendu rend inutile la présence de décodeur spécifique.

Avant de décrire le fonctionnement du circuit de la figure 1, il convient de rappeler que le circuit d'interface 6 a pour fonction en réception de décoder les commandes reçues de la ligne SDA et de les transmettre au circuit de commande 2. L'interface 6 effectue également la conversion série-parallèle des adresses et des données reçues avant de les transmettre respectivement au registre d'adresse AD-R et au registre de données d'entrée DTi-R. En émission, sous le contrôle du circuit de commande 2, l'interface 6 effectue la conversion parallèle-série des données émises par la mémoire. Ces données peuvent être les données lues contenues dans le registre de données de sortie DTo-R ou dans la bascule de sortie B0 ou encore des informations de contrôle prévues par le protocole de communication du bus utilisé.

Comme pour une mémoire classique, une opération d'écriture est sollicitée par une commande d'écriture reçue par l'interface 6. La commande est prise en compte par le circuit de commande 2 qui active le circuit de programmation 7, les décodeurs 3, 4 de lignes et de colonnes ainsi que le registre d'adresse AD-R et le registre de données d'entrée DTi-R. Dans le cas d'une mémoire classique, le circuit de programmation exécute un cycle de programmation qui consiste à appliquer une impulsion de tension calibrée en niveau et en durée. Cette impulsion sert à charger ou décharger les grilles flottantes des transistors sélectionnés par les décodeurs en fonction de l'adresse reçue.

Dans le cas de l'invention, une opération d'écriture implique l'exécution de trois cycles successifs de programmation tels que schématisés à la figure 2. Le premier cycle CY1 consiste à programmer une cellule témoin sélectionnée dans la matrice 9 par le décodeur de lignes 3 en fonction de l'adresse de ligne (poids forts de l'adresse) et par le décodeur de colonnes 10 en fonction de l'adresse de colonne (poids faibles de l'adresse). Ce premier cycle a pour but de programmer le transistor de la cellule sélectionnée à une première valeur logique déterminée correspondant par exemple à un état passant de ce transistor qui, par convention, définit la valeur 1 logique. Le cycle CY1 est alors suivi d'un second cycle de programmation CY2 réalisant l'écriture dans la matrice 1 de la donnée contenue dans le registre de données d'entrée DTi-R à l'adresse contenue dans le registre d'adresse AD-R. Le second cycle pourrait en fait consister en deux cycles successifs : un premier cycle pour effectuer une remise à 0 du mot adressé et un second cycle pour effectuer la mise à 1 de cellules sélectionnées. Le cycle CY2 est enfin suivi d'un troisième cycle de programmation CY3 pour effectuer la remise à 0 de la cellule témoin sélectionnée.

Les opérations de lecture de données contenues dans la matrice 1 s'effectuent de façon classique. Par contre, la lecture des cellules témoins nécessite une commande spéciale applicable par exemple à une borne d'entrée supplémentaire de l'interface 6 ou incluse dans le protocole de communication du bus. Cette commande de test CT doit s'accompagner de l'envoi d'une adresse permettant au décodeur 10 de sélectionner la cellule témoin associée à cette adresse. L'état de la cellule sélectionnée est transféré dans la bascule de sortie B0 elle-même reliée à l'interface 6. L'état de la bascule B0 peut être directement disponible sur une borne de sortie de l'interface 6 sous la forme d'un signal de test RT.

Selon une variante de réalisation représentée à la figure 3, on pourra prévoir une bascule de test BT initialement mise à 0, dont l'entrée de positionnement S est reliée à la bascule de sortie B0. L'état de la bascule de test BT peut alors servir à fournir un second signal de test RT accessible sur une borne de sortie de l'interface 6. Selon cette variante, le circuit de commande 2 est conçu pour effectuer automatiquement à la suite du troisième cycle de programmation CY3 une commande de lecture de la cellule témoin impliquée. En prévoyant une mise à 0 de la bascule de test BT à chaque mise sous tension de la mémoire, l'état de la bascule de test BT et par conséquent le signal RT seront alors représentatifs de la qualité de l'ensemble des programmations effectuées depuis la dernière mise sous tension de la mémoire. Selon une autre possibilité, la mise à 0 initial peut être commandée par le circuit de commande 2 en réponse à une sollicitation externe. Cette variante de réalisation peut s'appliquer quels que soient l'organisation de la mémoire et le nombre de cellules témoins.

## Revendications

1. Mémoire non volatile modifiable électriquement comportant un ensemble de cellules mémoire (1), des moyens d'adressage (3, 4) et de programmation (7) desdites cellules (1), un circuit d'interface (6), et au moins une cellule mémoire supplémentaire (9), ci-après appelée cellule témoin, l'ensemble étant commandé par un circuit de commande (2) comprenant des moyens (10, 11) pour commander sélectivement la programmation de ladite cellule témoin (9), caractérisée en ce ce qu'en réponse à toute commande d'écriture reçue par ledit circuit d'interface (6), le circuit de commande active trois cycles de programmation successifs (CY1, CY2, CY3) :
- un premier cycle de programmation (CY1) de ladite cellule témoin (9) pour effectuer l'écriture d'une première valeur logique binaire déterminée,
- un second cycle de programmation (CY2) réalisant l'écriture dans ledit ensemble de cellules mémoire (1) de données à écrire et
- un troisième cycle de programmation (CY3) de ladite cellule témoin pour effectuer l'écriture d'une seconde valeur logique complémentaire de la première.

2. Mémoire selon la revendication 1, caractérisée en ce qu'elle comporte une seule cellule témoin (9).

3. Mémoire selon la revendication 2, caractérisée en ce que ledit circuit d'interface (6) communique avec ladite cellule témoin (9) pour fournir un premier signal de test (RT0) représentatif de l'état de ladite cellule témoin (9).

4. Mémoire selon la revendication 2, caractérisée en ce qu'elle comporte une bascule de test (BT) initialement mise à zéro, en ce qu'à la suite dudit troisième cycle de programmation (CY3), le circuit de commande (2) effectue une lecture de ladite cellule témoin et applique le résultat de ladite lecture à l'entrée de positionnement (S) de ladite bascule de test (BT) et en ce que ledit circuit d'interface (6) communique avec ladite bascule de test (BT) pour fournir un second signal de test (RT) représentatif de l'état de ladite bascule de test (BT).

5. Mémoire selon la revendication 1, caractérisée en ce qu'elle est organisée en mots de taille fixe associés à des adresses correspondantes et comporte une cellule témoin (9) par bloc de mots, un bloc de mots ayant un nombre déterminé de bits d'adresse communs et en ce qu'en réponse à une commande d'écriture d'un mot d'un desdits blocs dans la mémoire, le circuit de commande sélectionne une desdites cellules témoins en fonction desdits bits d'adresse communs et applique lesdits premier et troisième cycles de programmation (CY1, CY3) à ladite cellule témoin sélectionnée.

6. Mémoire selon la revendication 5, caractérisée en ce que ledit circuit d'interface (6) est prévu pour recevoir un signal externe de commande de test (CT) et en ce qu'en réponse à une commande de lecture et audit signal de commande de test (CT), le circuit de commande (2) effectue la lecture de la cellule témoin (9) adressée par les poids forts de l'adresse associée à ladite commande de lecture pour fournir un premier signal de test (RT0) représentatif de l'état de ladite cellule témoin (9).

7. Mémoire selon la revendication 1, caractérisée en ce qu'elle est organisée en mots de taille fixe associés à des adresses correspondantes et comporte une cellule témoin (9) par mot et en ce qu'en réponse à une commande d'écriture d'un mot, le circuit de commande sélectionne une desdites cellules témoins en fonction de l'adresse dudit mot et applique lesdits premier et troisième cycles de programmation (CY1, CY3) à ladite cellule témoin sélectionnée.

8. Mémoire selon la revendication 7, caractérisée en ce que ledit circuit d'interface (6) est prévu pour recevoir un signal externe de commande de test (CT) et en ce qu'en réponse à une commande de lecture et audit signal de commande de test (CT), le circuit de commande (2) effectue la lecture de la cellule témoin (9) sélectionnée par l'adresse associée à ladite commande de lecture pour fournir un premier signal de test (RT0) représentatif de l'état de ladite cellule témoin (9).

9. Mémoire selon l'une des revendications 5 à 8, caractérisée en ce qu'elle comporte une bascule de test (BT) initialement mise à zéro, en ce qu'à la suite dudit troisième cycle de programmation (CY3), le circuit de commande (2) effectue une lecture de ladite cellule témoin sélectionnée et applique le résultat de ladite lecture à l'entrée de positionnement (S) de ladite bascule de test (BT) et en ce que ledit circuit d'interface (6) communique avec ladite bascule de test (BT) pour fournir un second signal de test (RT) représentatif de l'état de ladite bascule de test (BT).

## Patentansprüche

1. Nicht-flüchtiger, elektrisch veränderbarer Speicher, umfassend eine Anordnung von Speicherzellen (1), Mittel zur Adressierung (3, 4) und Programmierung (7) dieser Zellen (1), eine Schnittstellenschaltung (6) und zumindest eine zusätzliche, nachstehend als Vergleichszelle bezeichnete Speicherzelle (9), wobei die Anordnung durch eine Steuerschaltung (2) gesteuert wird, welche Mittel (10, 11) zum selektiven Steuern der Programmierung der Vergleichszelle (9) umfaßt, dadurch gekennzeichnet, daß die Steuerschaltung in Antwort aufjeden durch die Schnittstellenschaltung (6) empfangenen Schreibbefehl drei aufeinanderfolgende Programmierungszyklen (CY1, CY2, CY3) in Gang setzt:
- einen ersten Programmierungszyklus (CY1) der Vergleichszelle (9) zum Durchführen des Schreibens eines ersten vorbestimmten, logischen, binären Werts,
- einen zweiten Programmierungszyklus (CY2), welcher das Schreiben von zu schreibenden Daten in die Anordnung von Speicherzellen (1) durchführt, und
- einen dritten Programmierungszyklus (CY3) der Vergleichszelle zum Durchführen des Schreibens eines zweiten, zu dem ersten komplementären logischen Werts.

2. Speicher nach Anspruch 1, gekennzeichnet durch eine einzige Vergleichszelle (9).

3. Speicher nach Anspruch 2, dadurch gekennzeichnet, daß die Schnittstellenschaltung (6) mit der Vergleichszelle (9) kommuniziert, um ein erstes, den Zustand der Vergleichszelle (9) repräsentierendes Prüfsignal (RT0) bereitzustellen.

4. Speicher nach Anspruch 2, dadurch gekennzeichnet, daß ein anfänglich auf Null gesetztes Prüfkippglied (BT) vorgesehen ist, daß auf den dritten Programmierungszyklus (CY3) folgend die Steuerschaltung (2) einen Lesevorgang der Vergleichszelle durchführt und das Ergebnis dieses Lesevorgangs an den Setzeingang (S) des Prüfkippglieds (BT) anlegt, und daß die Schnittstellenschaltung (6) mit dem Prüfkippglied (BT) kommuniziert, um ein zweites Prüfsignal (RT) bereitzustellen, welches den Zustand des Prüfkippglieds (BT) repräsentiert.

5. Speicher nach Anspruch 1, dadurch gekennzeichnet, daß dieser in Worten fester Breite, die entsprechenden Adressen zugeordnet sind, organisiert ist und eine Vergleichszelle (9) pro Block von Worten umfaßt, wobei ein Block von Worten eine bestimmte Anzahl von gemeinsamen Adreßbits aufweist, und daß die Steuerschaltung in Antwort auf einen Befehl zum Schreiben eines Wortes eines dieser Blöcke in den Speicher in Abhängigkeit von den gemeinsamen Adreßbits eine der Vergleichszellen auswählt und den ersten und den dritten Programmierungszyklus (CY1, CY3) an der ausgewählten Vergleichszelle ausführt.

6. Speicher nach Anspruch 5, dadurch gekennzeichnet, daß die Schnittstellenschaltung (6) dazu vorgesehen ist, ein externes Prüfsteuersignal (CT) zu empfangen, und daß die Steuerschaltung (2) in Antwort auf einen Lesebefehl und auf das Prüfsteuersignal (CT) hin die durch starke Gewichtung der dem Lesebefehl zugeordneten Adresse adressierte Vergleichszelle (9) ausliest, um ein erstes, den Zustand der Vergleichszelle (9) repräsentierendes Prüfsignal (RT0) bereitzustellen.

7. Speicher nach Anspruch 1, dadurch gekennzeichnet, daß dieser in Worten fester Breite, die entsprechenden Adressen zugeordnet sind, organisiert ist und eine Vergleichszelle (9) pro Wort umfaßt, und daß die Steuerschaltung in Antwort auf einen Schreibbefehl eines Wortes in Abhängigkeit von der Adresse des Worts eine der Vergleichszellen auswählt und den ersten und den dritten Programmierungszyklus (CY1, CY3) an der ausgewählten Vergleichszelle ausführt.

8. Speicher nach Anspruch 7, dadurch gekennzeichnet, daß die Schnittstellenschaltung (6) dazu vorgesehen ist, ein externes Prüfsteuersignal (CT) zu empfangen, und daß die Steuerschaltung (2) in Antwort auf einen Lesebefehl und auf das Prüfsteuersignal (CT) hin die durch die dem Lesebefehl zugeordnete Adresse ausgewählte Vergleichszelle (9) ausliest, um ein erstes, den Zustand der Vergleichszelle (9) repräsentierendes Prüfsignal (RT0) bereitzustellen.

9. Speicher nach einem der Ansprüche 5 bis 8, dadurch gekennzeichnet, daß ein anfänglich auf Null gesetztes Prüfkippglied (BT) vorgesehen ist, daß auf den dritten Programmierungszyklus (CY3) folgend die Steuerschaltung (2) einen Lesevorgang der ausgewählten Vergleichszelle durchführt und das Ergebnis dieses Lesevorgangs an den Setzeingang (S) des Prüfkippglieds (BT) anlegt, und daß die Schnittstellenschaltung (6) mit dem Prüfkippglied (BT) kommuniziert, um ein zweites Prüfsignal (RT) bereitzustellen, welches den Zustand des Prüfkippglieds (BT) repräsentiert.

## Claims

1. Electrically modifiable non-volatile memory including a set of memory cells (1), means of addressing (3, 4) and programming (7) the said cells (1), an interface circuit (6) and at least one additional memory cell (9), hereinafter referred to as a reference cell, the whole being controlled by a control circuit (2) comprising means (10, 11) of selectively controlling the programming of the said reference cell (9), characterised in that, in response to any write command received by the said interface circuit (6), the control circuit activates three successive programming cycles (CY1, CY2, CY3):
- a first programming cycle (CY1) for the said reference cell (9), to write a first predetermined binary logic value,
- a second programming cycle (CY2) writing data to be written in the said set of memory cells (1), and
- a third programming cycle (CY3) for the said reference cell, to write a second logic value complementary to the first.

2. Memory according to Claim 1, characterised in that it includes a single reference cell (9).

3. Memory according to Claim 2, characterised in that the said interface circuit (6) communicates with the said reference cell (9) to supply a first test signal (RT0) representing the state of the said reference cell (9).

4. Memory according to Claim 2, characterised in that it includes a test flip-flop (BT), initially set at zero, in that, following the said third programming cycle (CY3), the control circuit (2) reads the said reference cell and applies the result of the said reading to the positioning input (S) of the said test flip-flop (BT) and in that the said interface circuit (6) communicates with the said test flip-flop (BT) to supply a second test signal (RT) representing the state of the said test flip-flop (BT).

5. Memory according to Claim 1, characterised in that it is organised into words of fixed size, associated with corresponding addresses, and includes one reference cell (9) per block of words, a block of words having a predetermined number of common address bits, and in that, in response to a command to write a word from one of the said blocks to the memory, the control circuit selects one of the said reference cells according to the said common address bits and applies the said first and third programming cycles (CY1, CY3) to the said reference cell selected.

6. Memory according to Claim 5, characterised in that the said interface circuit (6) is designed to receive an external test control signal (CT) and in that, in response to a read command and to the said test control signal (CT), the control circuit (2) reads the reference cell (9) addressed by the most significant elements of the address associated with the said read command in order to supply a first test signal (RT0) representing the state of the said reference cell (9).

7. Memory according to Claim 1, characterised in that it is organised into words of fixed size associated with corresponding addresses, and includes one reference cell (9) per word, and in that, in response to a command to write a word, the control circuit selects one of the said reference cells according to the address of the said word and applies the said first and third programming cycles (CY1, CY3) to the said reference cell selected.

8. Memory according to Claim 7, characterised in that the said interface circuit (6) is designed to receive an external test control signal (CT) and in that, in response to a read command and to the said test control signal (CT), the control circuit (2) reads the reference cell (9) selected by the address associated with the said read command to supply a first test signal (RT0) representing the state of the said reference cell (9).

9. Memory according to one of Claims 5 to 8, characterised in that it includes a test flip-flop (BT), initially set at zero, in that, following the said third programming cycle (CY3), the control circuit (2) reads the said selected reference cell and applies the result of the said reading to the positioning input (S) of the said test flip-flop (BT) and in that the said interface circuit (6) communicates with the said test flip-flop (BT) to supply a second test signal (RT) representing the state of the said test flip-flop (BT).
